Europäisches Patentamt

European Patent Office

Office européen des brevets

(19)

(11) Numéro de publication : **0 082 071**
**B1**

(12)                           FASCICULE DE BREVET EUROPÉEN

(45) Date de publication du fascicule du brevet :
**11.02.87**

(51) Int. Cl.⁴ : **H 03 K 17/08**

(21) Numéro de dépôt : **82402248.7**

(22) Date de dépôt : **08.12.82**

(54) **Dispositif pour la commutation d'une source de tension électrique continue pourvu d'au moins un interrupteur commandé et circuit d'aide à la commutation pour un tel dispositif.**

(30) Priorité : **14.12.81 FR 8123292**

(43) Date de publication de la demande :
**22.06.83 Bulletin 83/25**

(45) Mention de la délivrance du brevet :
**11.02.87 Bulletin 87/07**

(84) Etats contractants désignés :
**BE CH DE GB IT LI NL SE**

(56) Documents cités :
**DE-A- 2 639 589**
**DE-A- 2 649 385**
**US-A- 4 093 877**

(73) Titulaire : **AEROSPATIALE Société Nationale Indus-trielle**
**37 boulevard de Montmorency**
**F-75781 Paris Cédex 16 (FR)**

(72) Inventeur : **Du Parc, Jacques G.M.**
**25 rue Pasteur**
**F-93360 Neuilly-Plaisance (FR)**

(74) Mandataire : **Bonnetat, Christian et al**
**Cabinet PROPI Conseils 23 rue de Léningrad**
**F-75008 Paris (FR)**

**0 082 071**

## Description

La présente invention concerne les dispositifs de commutation électrique associés à une source continue et pourvus d'au moins un interrupteur commandé, ainsi qu'un circuit d'aide à la commutation pour un tel dispositif de commutation.

Elle s'applique tout particulièrement, quoique non exclusivement, aux dispositifs de commutation à structure symétrique, comportant au moins deux interrupteurs commandés et donc deux circuits d'aide à la commutation et en particulier aux convertisseurs de type push-pull.

On sait que de tels dispositifs de commutation, par exemple des convertisseurs statiques à découpage, utilisent, comme interrupteur, soit des composants tels que des diodes, des thyristors, des transistors, etc..., soit des assemblages de composants globalement équivalents. Aussi, dans la présente description, par « interrupteur » on entend de façon générale un dipôle transitant une puissance électrique et susceptible de prendre alternativement deux états, à savoir un état passant pour lequel la tension aux bornes du dipôle est très faible ou nulle et le courant traversant le dipôle est imposé par un circuit électrique extérieur, et un état bloqué pour lequel le courant traversant le dipôle est très faible ou nul et la tension aux bornes du dipôle est imposée par ledit circuit extérieur.

On sait par ailleurs que le changement d'état d'un interrupteur s'accompagne de « pertes de commutation », qui sont d'autant plus importantes que le temps de commutation est moins négligeable. En effet, durant un changement d'état, la tension et le courant sont simultanément et transitoirement importants. Dans un système d'axes tension-courant, le dipôle présente ainsi une caractéristique qui dépend de ses propriétés intrinsèques et du circuit extérieur.

Bien entendu, on distingue les pertes de commutation à l'ouverture (passage de l'état passant à l'état bloqué) et les pertes de commutation à la fermeture (passage de l'état bloqué à l'état passant), la puissance de ces pertes étant proportionnelle à la fréquence de répétition des commutations.

De plus, certains interrupteurs sont fragiles et supportent difficilement les conditions de tension ou de courant intervenant pendant ou après la commutation, ce qui soit limite les performances du dispositif de commutation, soit nuit à la durée de vie desdits interrupteurs. On remarquera par ailleurs que la mise en parallèle ou en série d'interrupteurs, pour accroître la puissance commutée, s'avère presque toujours dangereuse au moment des commutations, à cause de la dispersion des caractéristiques internes des divers interrupteurs ; en particulier, si un interrupteur commute avant les autres, il doit supporter toute la tension ou tout le courant d'utilisation pendant un court instant.

Ainsi, pour remédier aux inconvénients précédents (pertes de commutation, fragilité des interrupteurs et difficulté de mise en parallèle ou en série d'interrupteurs), on a déjà pensé à associer aux interrupteurs des circuits (ou réseaux) d'aide à la commutation, encore appelés circuits de protection de commutation ou snubbers. Ces circuits d'aide à la commutation ont pour effet de modifier les caractéristiques d'ouvertude et de fermeture supportées par les interrupteurs.

De tels circuits d'aide à la commutation peuvent être actifs ou passifs. La présente invention ne concerne que les circuits d'aide passifs, c'est-à-dire constitués de composants passifs, mais assurant une protection de l'interrupteur associé aussi bien à l'ouverture qu'à la fermeture. Elle permet d'aider à la commutation des dispositifs particulièrement difficiles à protéger, à savoir les onduleurs ou convertisseurs statiques symétriques nécessitant au moins deux interrupteurs commandés en alternance.

Dans les circuits d'aide à la commutation connus, de type passif, on prévoit au moins un condensateur pour absorber la surtension d'ouverture et au moins une inductance pour absorber la surintensité de fermeture. Ces circuits connus nécessitent généralement un grand nombre de composants et sont mal adaptés aux dispositifs à structure symétrique. De plus, le condensateur doit être surdimensionné ou doublé car il doit supporter, au moment de la commutation, la même tension que l'interrupteur.

La présente invention concerne un dispositif de commutation passif de ce type, ne comportant pas de résistance (et donc non dissipatif), n'utilisant que peu de composants passifs et notamment qu'un seul condensateur supportant une tension inférieure à celle supportée par l'interrupteur.

Ainsi, par rapport aux dispositifs connus, on bénéficie d'un gain sur les composants et donc d'un gain de coût et de fiabilité.

Selon un premier aspect, la présente invention est plus précisément destinée à perfectionner le dispositif de commutation décrit dans le document DE-A1-2 639 589 et comportant une source de tension continue destinée à alimenter une charge inductive à laquelle est associée au moins une diode de roue libre, ce dispositif comportant au moins un interrupteur commandé, ainsi qu'un circuit d'aide à la commutation passif et non dissipatif comprenant :

— un condensateur relié d'un côté à l'extrémité dudit interrupteur commandé dirigée vers ladite charge et de l'autre côté à une première diode ;

— une inductance connectée en série avec ladite première diode ; et

— une seconde diode reliée au point commun audit condensateur et à ladite première diode, de façon que l'anode (cathode) de la première diode soit connectée à la cathode (anode) de ladite seconde diode.

Appliquée à un dispositif de commutation de ce type, la présente invention est alors caractérisée en ce que :

— une inductance principale est montée en série avec ledit interrupteur et en contiguïté avec l'extrémité de celui-ci reliée audit condensateur ;

— l'extrémité de ladite inductance opposée à ladite première diode est reliée à l'extrémité dudit interrupteur commandé opposée à ladite charge ; et

— l'électrode de ladite seconde diode opposée audit point commun est reliée à un point dont le potentiel est sensiblement fixe et supérieur ou inférieur au potentiel appliqué par ladite source à l'extrémité de l'interrupteur commandé opposée audit condensateur, suivant que ce dernier potentiel est négatif ou positif respectivement.

Selon un second aspect, la présente invention est particulièrement destinée à perfectionner le dispositif de commutation décrit dans le document US-A-4 093 877. Ce dispositif de commutation connu comporte une source de tension continue destinée à alimenter une charge inductive et au moins un interrupteur commandé, ainsi qu'un circuit d'aide à la commutation passif et non dissipatif comprenant :

— un condensateur relié d'un côté à l'extrémité dudit interrupteur commandé dirigée vers ladite charge et de l'autre côté à une première diode ;

— une inductance dont une extrémité est connectée en série avec ladite première diode et l'autre à l'extrémité dudit interrupteur commandé opposée à ladite charge ; et

— une seconde diode dont une électrode est reliée au point commun audit condensateur et à ladite première diode, de façon que l'anode (cathode) de la première diode soit connectée à la cathode (anode) de ladite seconde diode, et l'autre électrode est reliée à un point dont le potentiel est sensiblement fixe et supérieur ou inférieur au potentiel appliqué par ladite source à l'extrémité de l'interrupteur commandé opposée audit condensateur, suivant que ce dernier potentiel est négatif ou positif respectivement.

Dans ce cas, la présente invention est alors caractérisée en ce qu'une inductance principale est montée en série avec ledit interrupteur et en contiguïté avec l'extrémité de celui-ci reliée audit condensateur.

On voit ainsi que, dans les dispositifs conformes à l'invention, le condensateur supporte une tension alternativement positive et négative et de valeur moitié de la tension unidirectionnelle supportée dans le cas des dispositifs connus. Il en résulte que le condensateur peut être unique et de tension de service normale (sans surdimensionnement). Ainsi, le circuit selon l'invention peut ne comporter qu'un seul condensateur, deux diodes et deux inductances.

Comme on le verra par la suite plus en détail, à l'ouverture, la surtension due à la décharge de l'inductance principale est absorbée par le condensateur, la seconde diode étant alors conductrice, tandis qu'à la fermeture, la surintensité due à la décharge du condensateur est absorbée par l'inductance qui se trouve en série par l'intermédiaire de la première diode. Ainsi, par le choix de la capacité du condensateur et des valeurs des deux inductances, on peut fixer de façon avantageuse le compromis à l'ouverture entre le temps minimum d'ouverture nécessaire à la décharge de l'inductance principale et la surtension due à cette décharge et le compromis à la fermeture entre le temps minimum de fermeture nécessaire à la décharge du condensateur et la surintensité due à cette décharge.

De préférence, ledit point de potentiel sensiblement fixe auquel le condensateur est réuni par la seconde diode est tel que son potentiel correspond à la moitié de la tension supportée par l'interrupteur. Ainsi, dans les convertisseurs push-pull, ledit point de potentiel sensiblement fixe est la borne de la source continue opposée à la borne à laquelle est reliée l'extrémité de l'interrupteur commandé opposée à l'inductance principale. Par ailleurs, dans les autres convertisseurs, ce point de potentiel fixe est constitué par le point milieu de ladite source. Ce point milieu peut soit exister par principe (cas d'un convertisseur à double source, par exemple), soit être réalisé spécialement, par exemple à l'aide de condensateurs, pour la mise en œuvre de la présente invention.

Dans le cas où, de par sa structure, le dispositif de commutation selon l'invention comporte un transformateur, il est avantageux d'utiliser les selfs de fuite de ce transformateur pour réaliser ladite inductance principale. Ainsi, on profite d'un inconvénient pour le transformer en avantage.

Bien entendu, lorsque, comme cela est usuellement le cas, un dispositif de commutation perfectionné selon l'invention comporte plusieurs interrupteurs commandés, à chacun de ceux-ci est associé un circuit d'aide à la commutation comprenant ledit condensateur, lesdites première et seconde diodes, l'inductance principale et l'inductance auxiliaire et chacun de ces interrupteurs est disposé de façon décrite ci-dessus.

Les figures du dessin annexé feront bien comprendre comment l'invention peut être réalisée.

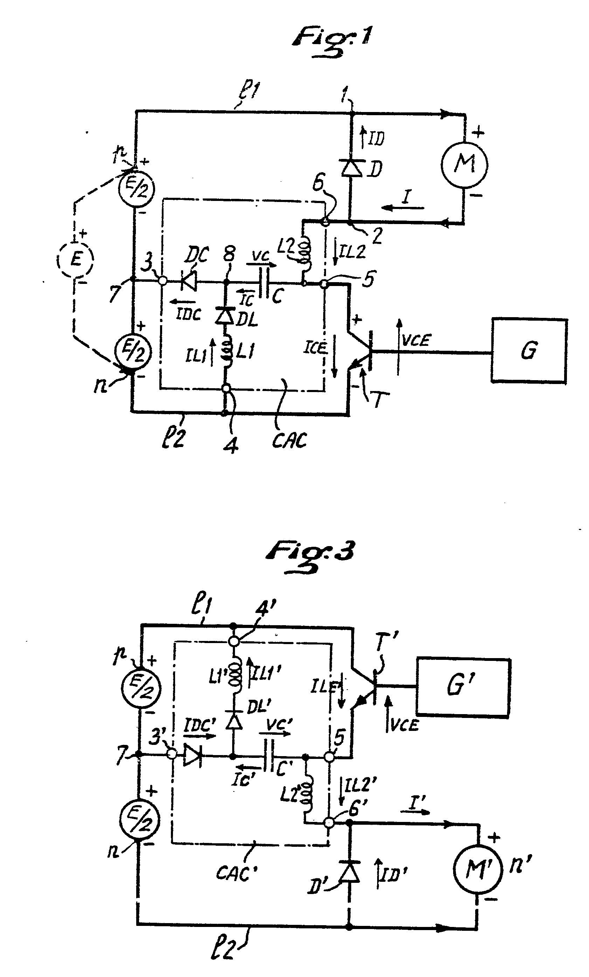

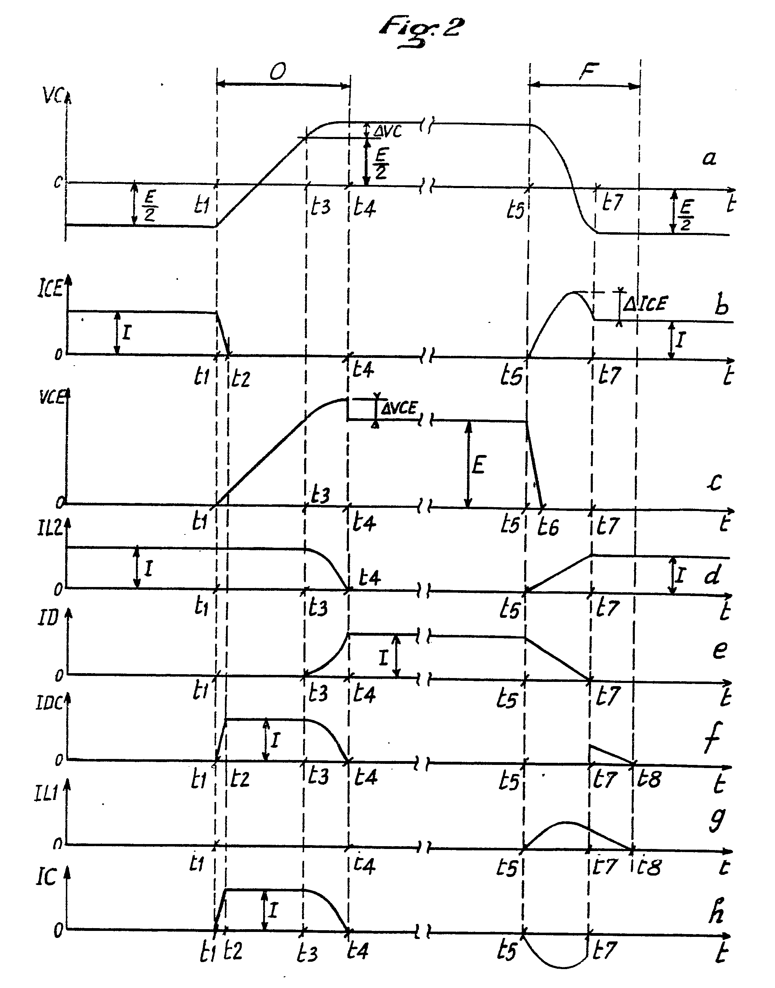

La figure 1 montre un dispositif de commutation simple selon l'invention.

Les diagrammes a à h de la figure 2 illustrent le fonctionnement du dispositif de la figure 1.

La figure 3 illustre une variante du dispositif de la figure 1.

La figure 4 montre un dispositif de commutation selon l'invention, de structure symétrique.

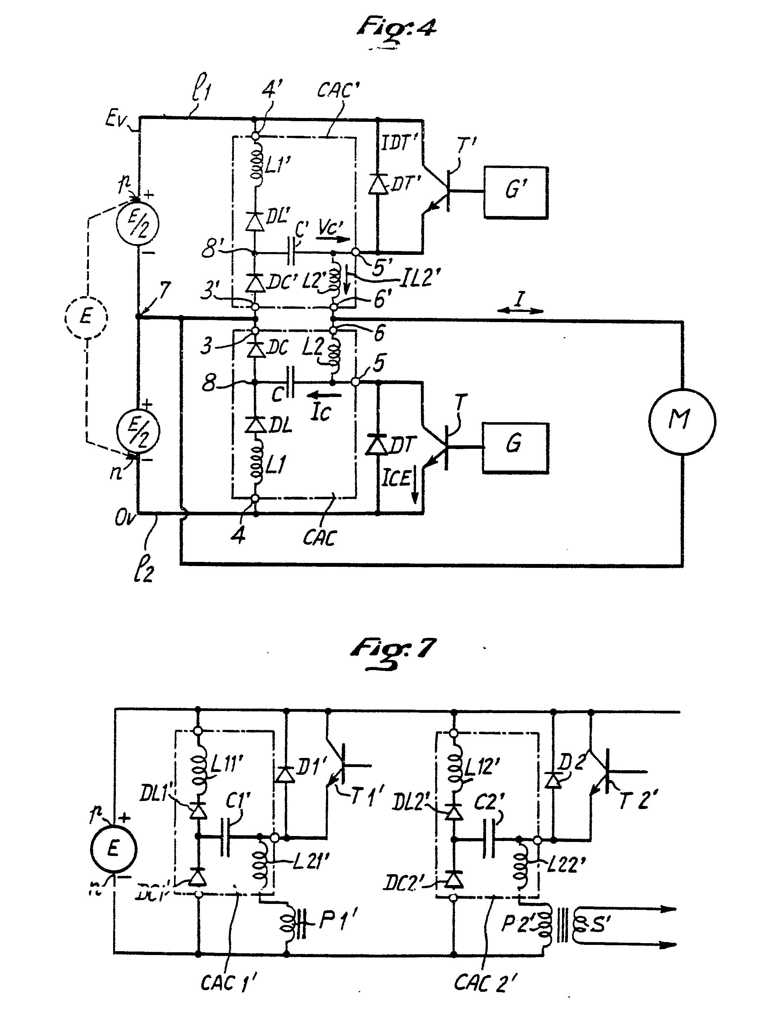

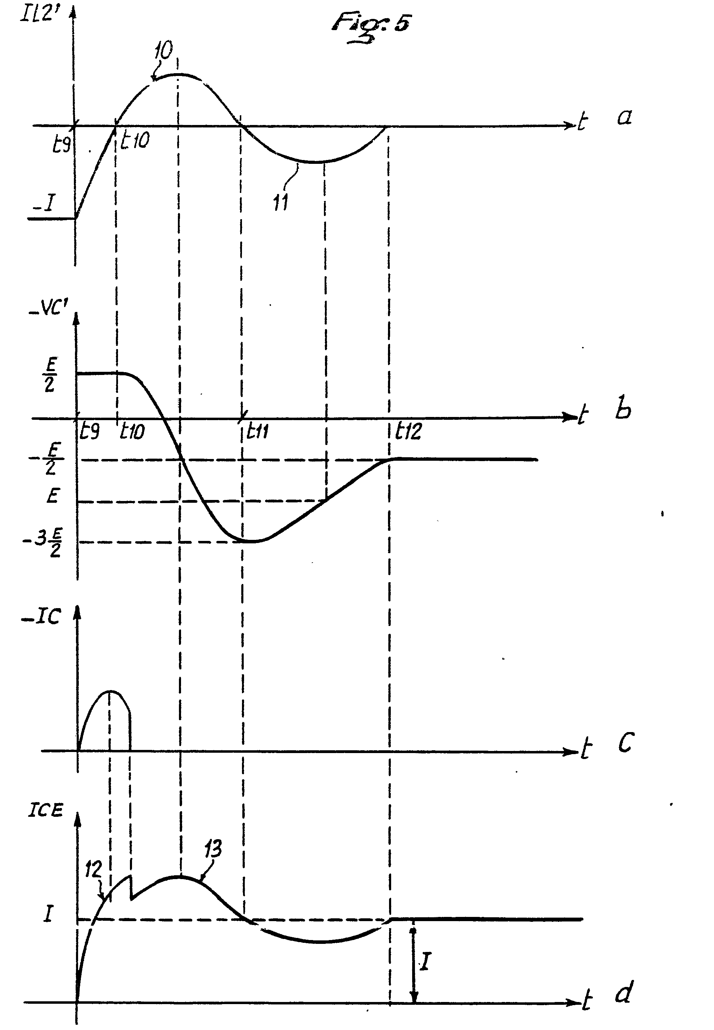

Les diagrammes a à d de la figure 5 illustrent une partie du fonctionnement du dispositif de la figure 4.

La figure 6 illustre l'application de l'invention à un convertisseur de structure push-pull.

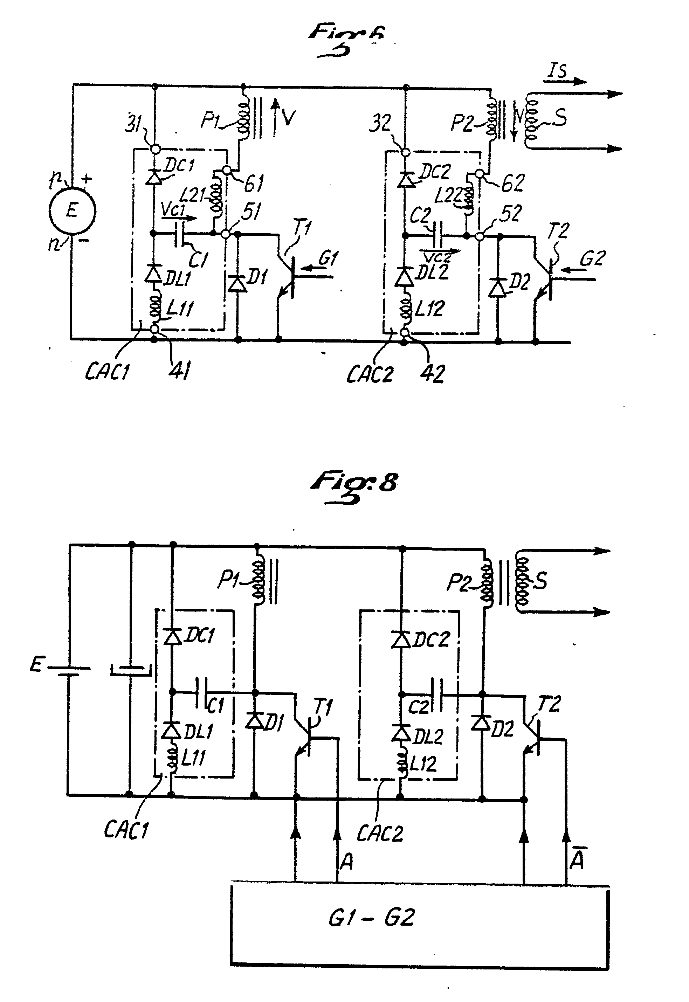

La figure 7 montre une autre structure de convertisseur push-pull à laquelle est appliquée l'invention.

La figure 8 montre une variante du dispositif de la figure 6, dans laquelle lesdites inductances

0 082 071

principales sont remplacées par les inductances de fuite entre les enroulements primaires.

Le circuit d'aide à la commutation selon l'invention, montré par la figure 1, où il porte la référence CAC, est illustré appliqué à un onduleur de type connu destiné à alimenter une charge, par exemple un moteur électrique M. Cet onduleur comporte un interrupteur commandé T, par exemple un transistor de puissance dont la conduction est commandée par des impulsions émises par un générateur G et appliquées sur la base dudit transistor. L'interrupteur T permet de hacher la tension continue d'une source E, au rythme des impulsions de commande du générateur G et d'alimenter le moteur M avec ces impulsions découpées. La diode D aux bornes de la charge M sert de diode de roue libre.

A cette fin, le pôle positif p de la source E est relié au point 1 commun à la cathode de la diode D et à la borne positive du moteur M par une ligne $l_1$, tandis que le pôle négatif n de la source E est réuni au point commun 2 à l'anode de la diode D et à la borne négative du moteur M par une ligne $l_2$, l'interrupteur T étant interposé dans la ligne $l_2$.

Le circuit CAC est relié à l'onduleur en quatre bornes 3, 4, 5 et 6. La borne 3 est réunie à un point milieu 7 subdivisant la source E en deux sources identiques moitié E/2, tandis que la borne 4 est reliée à la ligne $l_2$, entre le pôle négatif n et l'interrupteur T. Les bornes 5 et 6 réunies lorsque le circuit CAC n'existe pas, sont disposées dans la liaison $l_2$, entre l'interrupteur T et le point 2, et interrompent cette liaison $l_2$ lorsque le circuit CAC existe.

Le circuit CAC comporte, entre les bornes 5 et 3, le montage en série d'un condensateur C et d'une diode DC et, entre la borne 4 et le point commun 8 au condensateur C et à la diode DC, le montage en série d'une inductance L1 et d'une diode DL. Une inductance L2 relie les bornes 5 et 6.

Ainsi, le circuit CAC est tel que l'inductance L2 est montée en série entre la charge M et le transistor T et qu'une branche de circuit comprenant le montage en série d'un condensateur C, de la diode DL et de l'inductance L1 est montée en parallèle sur le trajet émetteur-collecteur du transistor T, de façon qu'une borne du condensateur C soit reliée à l'extrémité de l'inductance L2 dirigée vers le transistor T et que l'autre borne du condensateur C est reliée au point 7 de potentiel + E/2 moitié de la tension E supportée par l'interrupteur T, par l'intermédiaire de la diode DC, les diodes DL et DC étant bloquantes pour la tension E/2 appliquée aux bornes de la branche de circuit comportant en série les diodes DL et DC et l'inductance L1.

Le circuit CAC ne comporte pas de résistance et il n'est donc pas dissipatif.

Le fonctionnement du circuit d'aide à la consommation CAC de la figure 1 est illustré par les diagrammes de la figure 2 qui montrent en fonction du temps t, l'évolution de différents paramètres électriques de ce circuit. Sur les diagrammes de la figure 2, on a supposé que l'interrupteur T était fermé de 0 à $t_1$, qu'on l'ouvrait à $t_1$ et qu'on le refermait à $t_5$, l'ouverture O du circuit s'effectuant de $t_1$ à $t_4$, tandis que la fermeture F s'étend de $t_5$ à $t_8$.

A l'état initial, c'est-à-dire lorsque l'interrupteur T est fermé (entre 0 et $t_1$), le courant ICE du trajet collecteur-émetteur du transistor T et le courant IL2 traversant l'inductance L2 sont égaux au courant I traversant la charge M (voir les figures 2b et 2d). La tension VC aux bornes du condensateur C est alors égale à — (E/2) (figure 2a) comme on le vérifiera par la suite. Pendant cet état initial, seul le transistor T est conducteur, les diodes D, DC et DL étant bloquées.

L'ouverture O du circuit (de $t_1$ à $t_4$) se décompose en trois périodes :

— de $t_1$ à $t_2$, le transistor T reste conducteur, mais comme il possède un pouvoir intrinsèque de coupure important, il impose la chute rapide de son courant ICE qui passe de la valeur I à la valeur 0 (figure 2b). Corrélativement, le condensateur C, dont la tension aux bornes VC devient moins négative, empêche tout accroissement brusque de la tension VCE (figure 2c) aux bornes du transistor T et la diode DC devient passante. Par suite, le courant IDC qui la traverse est égal au courant de charge IC du condensateur C et les courants IDC et IC passent concomitamment de la valeur 0 à la valeur I (figures 2f et 2h), en sens opposé au courant ICE, de façon à maintenir l'égalité IC + ICE = I = IL2.

On suppose que la capacité du condensateur C est suffisamment grande pour que la variation de la tension VC reste négligeable de sorte que l'intervalle de temps $t_2 - t_1$ est négligeable par rapport à $t_3 - t_1$ et que les pertes de commutation à l'ouverture qui sont égales à

$$\left]_{t_1}^{t_2}\right.$$

VCE × ICE × dt restent très faibles.

De $t_2$ à $t_3$, le transistor T est éteint et la diode de roue libre D n'est pas encore passante, de sorte que seule la diode DC est conductrice (DL étant toujours bloquée). La charge M maintient l'égalité IDC = IC = IL2 = I. La tension aux bornes de l'inductance L2 est nulle et le condensateur C se charge linéairement (voir VC sur la figure 2a). La tension aux bornes de la diode de roue libre D, qui est égale à VC — (E/2) reste négative mais croît avec VC et, à l'instant $t_3$ pour lequel VC = E/2, elle devient nulle. La diode D s'amorce donc.

De $t_3$ à $t_4$, les diodes D et DC sont donc passantes, alors que le transistor T et la diode DL sont bloqués. Le courant ID traversant la diode D croît de 0 à I (voir figure 2e), tandis que les courants IDC, IC et IL2, qui sont égaux, décroissent de I à 0. Cette décroissance est telle que l'égalité I = ID + IL2 est respectée. Comme le montrent les différents diagrammes de la figure 2, la loi de variation des tensions et courants n'est plus linéaire, mais correspond à une portion de période du circuit oscillant formé par L2, C,

4

DC, E/2 et D, avec pour conditions initiales une tension nulle (à l'instant $t_3$ la tension VC est compensée par la source E/2) et un courant I non nul.

L'instant $t_4$ correspond à la fin de l'ouverture, marquée par le blocage de la diode DC et des surtensions ΔVCE et ΔVC apparaissant respectivement aux bornes du transistor T et du condensateur C. La surtension ΔVCE disparaît brusquement, tandis que la surtension ΔVC (au-dessus de + E/2) se maintient à cause de la décharge de l'inductance L2. Cette surtension ΔVC est égale à $I\sqrt{L2/C}$.

Après l'instant $t_4$, le circuit se trouve dans un état intermédiaire durant jusqu'à l'instant $t_5$. Dans cet état intermédiaire, le transistor T et les diodes DC et DL sont bloquées et seule la diode de roue libre D est conductrice. La tension VC reste supérieure à + (E/2) tandis que la tension VCE est égale à E. Le courant de charge I s'écoule en roue libre à travers la diode D.

La fermeture F du circuit (de $t_5$ à $t_8$) peut également être décomposée en trois périodes :

— de $t_5$ à $t_6$, le transistor T s'amorce, de sorte que la tension VCE passe rapidement de E à 0, ce qui a pour conséquence de rendre la diode DL conductrice et de maintenir bloquée la diode DC. Les inductances L1 et L2 limitent alors la croissance de courant ICE. Ces inductances L1 et L2 sont supposées suffisamment grandes pour que la croissance de ICE soit encore négligeable à l'instant $t_6$, de sorte que l'intervalle de temps $t_6 - t_5$ est également négligeable devant l'intervalle $t_7 - t_5$. Les pertes de commutation à l'ouverture qui sont égales à

$$\int_{t_5}^{t_6}$$

VCE × ICE × dt sont donc très faibles.

De $t_6$ à $t_7$, seule la diode DC est bloquée. La tension VCE est nulle et le courant ICE traversant le transistor T est la somme des courants traversant les inductances L1 et L2 : ICE = IL1 + IL2 le courant IL1 étant égal à — IC. Le courant IL2 croît linéairement de 0 à I, tandis que ID décroît linéairement de I à 0 avec ID + IL2 = I. Le courant IL1 = — IC est, quant à lui, sinusoïdal, car il provient du circuit oscillant série L1 — C (DL et T sont alors des courts-circuits) ayant pour conditions initiales un courant nul et une tension VC supérieure à E/2. La diode DC finit par se débloquer, car elle supporte une tension cathode-anode égale à VC + (E/2) ; or, VC qui était supérieure à E/2 à l'instant $t_5$ tend à s'inverser du fait de l'oscillation. La diode DC se débloque à l'instant $t_7$, auquel la tension VC atteint la valeur — (E/2).

La diode D peut se bloquer avant ou après que la diode DC s'amorce. A des fins de simplification, on a supposé sur la figure 2 que les deux événements intervenaient au même instant $t_7$.

La surintensité ΔICE traversant le transistor T est alors égale à

$$\left[\frac{E}{2} \pm I\sqrt{\frac{L2}{C}}\right]\sqrt{\frac{C}{L1}}.$$

de $t_7$ à $t_8$, seule la diode D est bloquée. A l'instant $t_7$, le courant IL1 bascule brusquement du condensateur C vers la diode DC de sorte que IC = O et IDC = IL1. L'inductance L1 finit par se décharger dans la source E suivant une loi linéaire. Par ailleurs, la diode de roue libre D est bloquée, le courant IL2 reste constant et égal à I. A l'instant $t_8$, le courant IL1 devient nul. Les deux diodes DC et DL se bloquent et l'on se retrouve à l'état initial.

La figure 1 illustre l'invention dans le cas où la charge M se trouve, par rapport au sens de circulation du courant de charge I, en amont de l'interrupteur T. Sur la figure 3, on a illustré le cas où c'est l'interrupteur T' qui se trouve en amont de la charge M'. Sur cette figure, les éléments correspondant à la figure 1 sont affectés de l'indice prime.

Le circuit CAC' de la figure 3 présente une structure semblable au circuit CAC, à la différence près que les diodes DC' et DL' sont de sens inverse, de façon à être bloquantes pour la partie de source E/2 sur laquelle la branche DC', DL', L1' est montée en parallèle. En effet, la borne 4' se trouve sur la ligne $l_1$, entre le pôle positif (p) et l'interrupteur T'. L'inductance L2' est également montée en série entre la charge M' et le transistor T' et la branche de circuit comprenant le montage série du condensateur C', de la diode DL' et de l'inductance L1' est montée en parallèle sur le transistor T', de façon qu'une borne de condensateur C' soit reliée à l'extrémité de l'inductance L2' dirigée vers le transistor T et que l'autre borne de condensateur C' soit reliée au point 7 de potentiel + (E/2) moitié de la tension E supportée par l'interrupteur T', par l'intermédiaire de la diode DC'.

Le fonctionnement du circuit CAC' est identique à celui du circuit CAC expliqué en regard de la figure 2.

Sur la figure 4, on a illustré un convertisseur à structure symétrique permettant d'alimenter une charge unique M alternativement avec des impulsions positives et négatives. Ce convertisseur comporte une source continue E subdivisée en deux demi-sources E/2, ayant un point commun 7. Dans la ligne partant du pôle p est interposé un transistor T', actionné par un générateur G'. On prévoit un circuit d'aide CAC' dont la borne 4' est reliée à la ligne $l_1$, entre le pôle p et le transistor T', tandis que les bornes 3' et 5' sont respectivement réunies au point 7 et à l'extrémité du transistor T' opposée au pôle p.

De même, dans la ligne $l_2$ partant du pôle n est interposé un transistor T, actionné par un générateur G. Un circuit d'aide CAC est monté de façon que sa borne 4 est reliée à la ligne $l_2$, entre le pôle n et le transistor T, tandis que les bornes 3 et 5 sont respectivement réunies au point 7 et à l'extrémité du transistor T opposée au pôle n.

La charge M est alimentée entre le point 7 et les bornes 6 et 6' réunies l'une à l'autre. Des diodes de roue libre DT et DT' sont respectivement montées en antiparallèle sur les transistors T et T'.

Les transistors T et T' sont commandés alternativement à l'ouverture et à la fermeture par les générateurs G et G', de sorte que le courant de charge I traversant la charge M change alternativement de sens.

Pour expliquer le fonctionnement du dispositif de la figure 4, on étudiera un cycle de commutation pendant lequel on commande le transistor T, le transistor T' restant toujours ouvert. Bien entendu, le cycle de commutation pour lequel on commande le transistor T' alors que le transistor T reste ouvert, présente un fonctionnement identique. On notera que le fonctionnement réel du dispositif de la figure 4 est extrêmement compliqué et que l'explication ci-après n'en est qu'une simplification destinée seulement à faire comprendre l'invention.

A l'état initial, on suppose donc que le transistor T est passant, alors que tous les autres transistors et diodes sont bloquants. Le courant de charge I (que l'on suppose alors négatif) s'écoule donc à travers l'inductance L2 et le transistor T, de la charge M vers le pôle négatif n de la source E. Par suite, les potentiels V5', V5, V6 et V6' respectivement des bornes 5', 5, 6 et 6' sont égaux à celui du pôle n, c'est-à-dire nuls. Par ailleurs, à cause des diodes DC' et DL', le potentiel V8' du point 8' est compris entre E/2 et E.

Il en résulte donc que la tension VC' aux bornes du condensateur C' est comprise entre E/2 et E. De façon comparable, à cause des diodes DC et DL, le potentiel V8 du point 8 est compris entre O et E/2, de sorte que la tension VC aux bornes du condensateur C est comprise entre — (E/2) et O. En réalité, VC est égale à — (E/2), car la diode DC était passante à la fin de la commutation précédente (fermeture de T) pour assurer la décharge de L1. Cette valeur est d'ailleurs nécessaire pour assurer la protection de T à l'ouverture.

Lorsque le transistor T s'ouvre, son courant ICE s'annule brusquement, de sorte que le courant de charge I s'écoule à travers l'inductance L2, le condensateur C et la diode DC, ce qui décharge le condensateur C et élève les potentiels V5 = V5' = V6 = V6' et donc également le potentiel V8'. Lorsque le potentiel V8' atteint la valeur E, la diode DL' devient passante ; à cet instant, on a E = V8' = (E/2) + VC + VC' VC' restant inchangée. A partir de cet instant, le courant I se partage à travers deux circuits en parallèle, à savoir le circuit L2, C et DC et le circuit L2', C', DL' et L1'. Le courant I étant constant, dIL2/dt est égal à dIL2'/dt et V6 = V6' = (V5 + V5')/2. Plusieurs possibilités de fonctionnement se présentent alors suivant l'ordre dans lequel se produisent les extinctions de DC et de DL' et l'amorçage de DT'. En outre, on peut aussi imposer V5' = E en amorçant le transistor T', de façon plus ou moins retardée. Ceci a pour effet d'accélérer la croissance des tensions et de réduire le temps global d'ouverture, surtout lorsque le courant I est faible. Un courant d'oscillation bref traverse le transistor T'. Enfin, suivant le cas, les diodes DC' et DL peuvent conduire brièvement en fin du cycle d'ouverture.

A la fin de l'ouverture du transistor T, on atteint donc un état intermédiaire dans lequel la diode DT' est passante, alors que tous les autres transistors ou diodes sont bloqués. Le courant I s'écoule alors à travers l'inductance L2' et la diode DT'. On a alors V5 = V5' = V6 = V6' = E. A cause de la présence des diodes DC' et DL', le potentiel V8' est compris entre E/2 et E, de sorte que la tension VC' aux bornes du condensateur C' est comprise entre E/2 et 0. Si la diode DC' est conductrice à la fin de l'ouverture du transistor T, L1' peut se décharger et VC' = — (E/2). De même, à cause de la présence des diodes DC et DL, le potentiel V8 est compris entre 0 et E/2, de sorte que la tension VC aux bornes du condensateur C est comprise entre E/2 et E.

Si maintenant, le générateur G commande le transistor T à la fermeture, le potentiel V5 passe brusquement de E à 0. Le courant ICE traversant le transistor T est égal à la différence du courant IL2 traversant l'inductance L2 et du courant IC du condensateur C. Ce courant IC est facile à analyser, puisque comme dans le cas de la figure 1, on a une demi-période de circuit oscillant LIC à travers DC et T, au terme de laquelle la tension VC s'est inversée. Le courant IL2 est plus difficile à analyser et son analyse est aidée par les diagrammes a et b de la figure 5, montrant respectivement le courant IL2' et la tension — VC'. En réalité, il y a trois phases successives.

Dans un premier temps (de $t_9$ à $t_{10}$) le transistor T et la diode DT' conduisent et V5' = E et V5 = 0. Par suite, le courant IDT' traversant la diode DT' est égal à l'opposé du courant IL2' traversant l'inductance L2' : ce courant IDT' décroît linéairement de I à 0, tandis que le courant IL2 croît linéairement de 0 à I. Pendant cette période, comme supposé ci-dessus, on a VC' = — (E/2).

Ensuite, à l'instant $t_{10}$, la diode DT' se bloque, mais la diode DC' se débloque. Il apparaît une demi-période 10 de circuit oscillant série C' — L2 — L2' à travers DC', T et la demi source E/2 comprise entre le pôle n et le point 7 avec pour conditions initiales un courant nul et une tension E.

Au terme $t_{11}$ de l'oscillation 10, la diode DC' se bloque et la tension VC' atteint une valeur élevée, de l'ordre de 3E/2 (en négligeant les pertes) ce qui entraîne le déblocage de DL' dès l'extinction de DC'.

Il s'ensuit une nouvelle demi-période 11 de circuit oscillant (avec pour conditions initiales un courant nul et une tension (3E/2) — E = E/2 entre le condensateur C' et les inductances L1', L2 et L2' en série, à travers la diode DL', le transistor T et les deux demi-sources E/2. Le courant correspondant se retranche du courant I dans le transistor T. Lorsque DL' se bloque (instant $t_{12}$), la tension VC' prend une valeur voisine de E/2.

6

La durée totale de la commutation de fermeture $(t_{12} - t_9)$ est donc imposée par le courant $IL_2'$ et est égale à

$$I \times \frac{L2 + L2'}{E} + \pi\sqrt{C'(L2 + L2')} + \pi\sqrt{C'(L1' + L2 + L2')}.$$

La surintensité dans le transistor T est plus difficile à évaluer. Il faut distinguer celle due à l'inversion du condensateur C (et qui porte la référence 12 sur le diagramme d de la figure 5) et celle due à l'inversion du condensateur C' (et qui porte la référence 13 sur le diagramme d de la figure 5). Ces inversions se produisent à des instants différents et les diagrammes d de la figure 5 montrent un exemple. Il faut noter en particulier que l'ouverture suivante du transistor T peut se produire dès que la tension VC atteint la valeur — (E/2') sans attendre l'inversion de VC', c'est-à-dire au bout d'un temps assez court.

La forme du courant ICE peut être très variée suivant les valeurs respectives de E, I, C', L1, L2, L1' et L2'.

Sur la figure 6, on a représenté un exemple d'application à un convertisseur push-pull du circuit d'aide à la commutation conforme à l'invention.

De façon connue, un tel convertisseur push-pull comporte un transformateur pourvu de deux primaires P1 et P2 couplés à un secondaire S. Chacun des primaires P1 et P2 est monté en parallèle sur une source continue E, respectivement par l'intermédiaire d'un interrupteur commandé (transistor par exemple) T1 ou T2. La conduction de chaque transistor T1 et T2 est commandée par la base de ceux-ci, reliée à des générateurs d'impulsion G1, G2. Dans l'exemple représenté, des diodes de roue libre D1 et D2 sont prévues « au primaire », respectivement en parallèle sur les transistors T1 et T2. Une charge (non représentée) est alimentée par le secondaire S.

Comme montré par la figure 6, on a ouvert chaque liaison entre un primaire P1 ou P2 et le transistor T1 ou T2 correspondant pour y insérer l'inductance L21 ou L22 (bornes 51, 52 et 61, 62) d'un circuit d'aide à la commutation selon l'invention, portant respectivement la référence CAC1 ou CAC2. Les divers éléments des circuits CAC1 et CAC2 portent les références des éléments correspondant du circuit CAC de la figure 1, affectées de l'indice 1 ou 2 suivant qu'ils appartiennent à CAC1 à CAC2. De plus, la borne 31 ou 32 de chaque circuit CAC1 et CAC2 est reliée à l'extrémité du primaire P1 ou P2 correspondant, opposée au transistor T1 ou T2. Enfin, la borne 41 ou 42 de chaque circuit CAC1 et CAC2 est reliée à l'extrémité du transistor T1 ou T2 correspondant, opposée à l'inductance L21 ou L22.

On sait qu'en fonctionnement, les impulsions de tension émetteur-collecteur des transistors T1 et T2 présentent des amplitudes VCE1 et VCE2 égales à deux fois la valeur de la tension E.

Ci-après, on analyse le fonctionnement du convertisseur push-pull de la figure 6 équipé des circuits CAC1 et CAC2 selon l'invention, en rapport avec l'état du transistor T1. Il va de soi que l'analyse est symétrique en fonction de l'état du transistor T2.

A l'état initial, seul le transistor T1 est conducteur, alors que le transistor T2 est bloqué et qu'il en est de même des différentes diodes DL1, DC1, D1 et DL2, DC2, D2. Le courant primaire I donnant naissance au courant de charge Is, (qui lui est proportionnel dans le rapport du transformateur) s'écoule à travers L21 et T1. Par suite, les potentiels V51 et V61 aux bornes 51 et 61 sont égaux entre eux et nuls. En revanche, les potentiels V52 et V62 des bornes 52 et 62 sont tous deux égaux à 2E. La tension VC2 aux bornes du condensateur C2 est comprise entre E et 2E, tandis que la tension VC1 aux bornes du condensateur C1 est égale à — E, car la diode DC1 était passante à la fin de la dernière commutation.

Lorsque le transistor T1 est commandé à l'ouverture par le générateur G1, il annule son courant émetteur-collecteur ICE1. Le courant de l'inductance L21, s'écoule à travers L21, C1 et DC1, la capacité C1 protégeant le transistor T1 en limitant la croissance linéaire de VCE1. Corrélativement, V51 et V61 croissent en restant égaux, tandis que la tension V aux bornes du primaire P1, V52, V62 et VD2 (tension aux bornes de la diode D2) décroissent jusqu'à ce que la diode DC2 s'amorce. A cet instant, on a V = VC2 — E = — VC1, de sorte que la somme des tensions VC1 et VC2 aux bornes des condensateurs C1 et C2 est égale à E, VC2 étant inchangée. Ensuite, le courant primaire se partage entre L21 et L22 avec IL21 — IL22 constant et proportionnel à IS et donc VL21 = VL22. Tout se passe comme dans le dispositif de la figure 4, le courant se partageant entre les deux circuits L21, C1, DC1 et L22, C2, DL2 et L12 en parallèle.

On a alors les égalités :

$$VC1 + VL21 + V = O$$

$$- VL12 + VC2 + VL22 - V = E$$

de sorte que

$$VC1 + VC2 + 2VL21 - VL12 = E \text{ et,}$$

$$VC1 - VC2 + 2V + VL12 = - E.$$

Plusieurs cas de fonctionnement sont alors possibles suivant l'ordre dans lequel se produisent les

7

extinctions de DC1 et DL2 et l'amorçage de DE, le phénomène pouvant être accéléré par l'amorçage du transistor T2.

On arrive donc à un état intermédiaire pour lequel la diode D2 est passante, toutes les autres diodes et les transistors T1 et T2 étant bloqués, le courant I s'écoulant à travers L22 et D2. On a alors

$$V62 = V52 = O$$

$$V61 = V51 = 2E$$

$$VC2 = — E$$

$$E \leqslant VC_1 \leqslant 2E.$$

Lorsque le générateur G1 commande le transistor T1, le courant ICE1 de ce transistor est égal à IL21 — IC1. Le courant IC1 du condensateur C1 résulte d'une demi-période d'oscillation du circuit oscillant L11 — C1 au terme de laquelle VC1 = — E (avec conduction brève de DC1 à la fin).

Le courant IL21 évolue en trois temps.

a) décroissance linéaire de ID2 = — IL22, de I jusqu'à zéro, IL21 croissant de zéro à I, cette décroissance étant terminée par le blocage de D2 ;

b) amorçage de DC2 : le couplage des deux primaires P1 et P2 revient alors à mettre L21 et L22 en série et tout se passe comme pour le dispositif de la figure 4.

On a en effet :

$$E = VL21 + V$$

$$O = VC2 + VL22 — V$$

d'où

$$E = VC2 + VL21 + VL22.$$

Au départ, VC2 = — E. Au terme d'une demi-période VC2 atteint une valeur théorique de 3E. A la fin, DC2 se bloque.

c) DL2 s'amorce aussitôt et, comme précédemment, le couplage des primaires revient à mettre L12, L21, L22 et C2 en série. Comme dans le dispositif de la figure 4, on a une autre demi-période de circuit oscillant au terme de laquelle VC2 = E.

Dans le dispositif de la figure 6, les interrupteurs T1 et T2 sont disposés du côté du pôle négatif n de la source E. Dans la variante de la figure 7, (dans laquelle les éléments correspondant à la figure 6 sont affectés d'un prime), les interrupteurs T'1 et T'2 sont disposés du côté du pôle positif p. Les circuits CAC'1 et CAC'2 sont donc modifiés en conséquence et sont semblables au circuit CAC' de la figure 3.

La figure 8 illustre un dispositif semblable à celui de la figure 6, dans lequel les inductances L21 et L22 sont remplacées par les selfs de fuite calibrées entre les deux primaires P1 et P2. Ces selfs de fuite peuvent être de l'ordre de quelques micro-Henry, de sorte qu'elles peuvent faire office d'inductances L21 et L22.

Par ailleurs, il peut exister également une self de fuite calibrée entre le secondaire S et les deux primaires P1 et P2. Cette dernière self de fuite peut être de l'ordre de quelques milli-Henry (mH) et elle peut remplacer l'inductance série du filtre de puissance, généralement disposé dans le circuit du secondaire S.

Pour obtenir ces différentes selfs de fuite, les primaires P1 et P2 et le secondaire S sont bobinés séparément, ce qui, compte-tenu des nombres différents de spires, facilite la réalisation et assure un excellent isolement galvanique.

Il est avantageux que le générateur G1-G2 de commande des transistors T1 et T2 puisse assurer une modulation du rapport cyclique à la fréquence d'utilisation. Pour cela, les impulsions de conduction A et $\bar{A}$ envoyées par le générateur G1-G2 sur les bases des transistors T1 et T2 peuvent résulter du découpage d'une tension de 50 KHz par un signal triangulaire de fréquence fixe, par exemple 5 KH$_z$. Ainsi, on peut balayer de nombreuses valeurs de rapport cyclique, et le circuit d'aide à la commutation selon l'invention présentant, comme on l'a dit ci-dessus, d'excellents compromis à l'ouverture et à la fermeture peut fonctionner avec des temps minimum d'ouverture et de fermeture aussi faibles que possibles.

Le dispositif de la figure 8 présente, pour la réalisation de convertisseur continu-alternatif avec isolement galvanique, des avantages déterminants tels que grande simplicité, excellente fiabilité, faible coût de revient, rendement important et excellente qualité du courant fourni à la charge.

En particulier, la réversibilité de l'énergie d'un circuit d'aide à la commutation sur l'autre facilite les asservissements et les protections et réduit fortement les phénomènes transitoires.

Quoique l'on ait décrit ci-dessus la présente invention appliquée à certaines structures particulières de convertisseurs, il va de soi qu'elle n'est pas limitée à celles-ci. On comprendra aisément que le circuit d'aide à la commutation selon l'invention peut être aussi bien appliqué à une structure en pont simple d'interrupteurs avec double source (comme par exemple sur la figure 4) qu'à une structure en pont d'interrupteurs double ou polyphasée avec simple ou double source. De même, elle s'applique à toutes les structures de convertisseurs push-pull, ainsi qu'à celle des convertisseurs isolés, symétriques ou asymétriques avec diode de roue libre au primaire ou au secondaire.

**Revendications**

1. Dispositif de commutation d'une source de tension continue (E) destinée à alimenter une charge inductive (M) à laquelle est associée au moins une diode de roue libre (D, D', DT, DT'), ce dispositif comportant au moins un interrupteur commandé (T, T'), ainsi qu'un circuit d'aide à la commutation (CAC, CAC') passif et non dissipatif comprenant :
— un condensateur (C, C') relié d'un côté (en 5, 5') à l'extrémité dudit interrupteur commandé dirigée vers ladite charge et de l'autre côté (en 8, 8') à une première diode (DL, DL') ;
— une inductance (L1, L1') connectée en série avec ladite première diode ;
— une seconde diode (DC, DC') reliée au point commun (8, 8') audit condensateur et à ladite première diode, de façon que l'anode (cathode) de la première diode soit connectée à la cathode (anode) de ladite seconde diode,
caractérisé en ce que :
— une inductance principale (L2, L2') est montée en série avec ledit interrupteur et en contiguïté avec l'extrémité de celui-ci reliée audit condensateur (C, C') ;
— l'extrémité (4, 4') de ladite inductance (L1, L1') opposée à ladite première diode (DL, DL') est reliée à l'extrémité dudit interrupteur commandé opposée à ladite charge (M) ; et
— l'électrode de ladite seconde diode (DC, DC') opposée audit point commun (8, 8') est reliée à un point (7) dont le potentiel est sensiblement fixe et supérieur ou inférieur au potentiel appliqué par ladite source à l'extrémité de l'interrupteur commandé opposée audit condensateur, suivant que ce dernier potentiel est négatif ou positif respectivement.

2. Dispositif de commutation d'une source de tension continue (E) destinée à alimenter une charge inductive (M), ce dispositif comportant au moins un interrupteur commandé (T1, T2), ainsi qu'un circuit d'aide à la commutation (CAC1, CAC2) passif et non dissipatif comprenant :
— un condensateur (C1, C2) relié d'un côté (en 51, 52) à l'extrémité dudit interrupteur commandé dirigée vers ladite charge et de l'autre côté (en 8, 8') à une première diode (DL1, DL2) ;
— une inductance (L11, L12) dont une extrémité est connectée en série avec ladite première diode et l'autre à l'extrémité dudit interrupteur commandé opposée à ladite charge (M) ; et
— une seconde diode (DC1, DC2) dont une électrode est reliée au point commun (8, 8') audit condensateur et à ladite première diode, de façon que l'anode (cathode) de la première diode soit connectée à la cathode (anode) de ladite seconde diode et l'autre électrode est reliée à un point (p) dont le potentiel est sensiblement fixe et supérieur ou inférieur au potentiel appliqué par ladite source à l'extrémité de l'interrupteur commandé opposée audit condensateur, suivant que ce dernier potentiel est négatif ou positif respectivement,
caractérisé en ce qu'une inductance principale (L21, L22) est montée en série avec ledit interrupteur et en contiguïté avec l'extrémité de celui-ci reliée audit condensateur (C1, C2).

3. Dispositif selon l'une des revendications 1 ou 2, caractérisé en ce que ledit point de potentiel sensiblement fixe (7, p) auquel le condensateur (C, C', C1, C2) est réuni par la seconde diode (DC, DC', DC1, DC2) est tel que son potentiel correspond à la moitié E/2 de la tension E supportée par l'interrupteur (T, T', T1, T2).

4. Dispositif selon les revendications 2 ou 3 caractérisé en ce qu'il présente la structure d'un convertisseur push-pull et en ce que ledit point de potentiel sensiblement fixe est la borne positive (p) ou négative (n) de la source continue E opposée à la borne négative (n) ou positive (p) à laquelle est reliée l'extrémité de l'interrupteur commandé (T1, T2) opposée à l'inductance principale (L21, L22).

5. Dispositif selon la revendication 3, caractérisé en ce que ledit point de potentiel sensiblement fixe est constitué par le point milieu 7 de la source E.

6. Dispositif selon l'une quelconque des revendications 1 à 5, caractérisé en ce qu'il présente la structure d'un convertisseur pourvu d'un transformateur isolant la charge des interrupteurs commandés et en ce que chaque inductance principale est formée par une self de fuite du transformateur.

7. Dispositif selon l'une quelconque des revendications 1 à 6, caractérisé en ce qu'il comporte plusieurs interrupteurs commandés (T, T', T1, T2) et en ce que, à chacun desdits interrupteurs commandés est associé un circuit d'aide à la commutation comprenant ledit condensateur (C, C', C1 et C2), lesdites première et seconde diodes (DL, DL', DL1, DL2-DC, DC', DC1, DC2), l'inductance principale (L2, L2', L21, L22) et l'inductance auxiliaire (L1, L1', L11, L12) et disposé tel que spécifié sous la revendication 1 ou la revendication 2.

## Claims

1. Device for switching a source of D.C. voltage (E) adapted to supply an inductive charge (M) with which is associated at least one free wheel diode (D, D', DT, DT'), said device comprising at least one controlled switch (T, T') as well as a passive and non-dissipative switching aid circuit (CAC, CAC') provided with :
— a capacitor (C, C') connected on one side (at 5, 5') to the end of said controlled switch directed towards said charge and on the other side (at 8, 8') to a first diode (DL, DL') ;
— an inductance (L1, L1') connected in series to said first diode ;
— a second diode (DC, DC') connected to the point (8, 8') common to said capacitor and to said first diode, such that the anode (cathode) of the first diode is connected to the cathode (anode) of said second diode,
characterized in that :
— a main inductance (L2, L2') is mounted in series with said switch and in contiguity with the end thereof connected to said capacitor (C, C') ;
— the end (4, 4') of said inductance (L1, L1') opposite to said first diode (DL, DL') is connected to the end of said controlled switch opposite to said charge (M) ; and
— the electrode of said second diode (DC, DC') opposite to said common point (8, 8') is connected to a point (7) the potential of which is substantially fixed and greater or lower than the potential applied by said source to the end of the controlled switch opposite to said capacitor, according to whether this latter potential is negative or positive respectively.

2. Device for switching a source of D.C. voltage (E) adapted to supply an inductive charge (M), the device comprising at least a controlled switch (T1, T2) as well as a passive and non-dissipative switching aid circuit (CAC1, CAC2) provided with :
— a capacitor (C1, C2) connected on one side (at 51, 52) to the end of said controlled switch directed towards said charge and on the other side (at 8, 8') to a first diode (DL1, DL2) ;
— an inductance (L11, L12) one end thereof being connected in series with said first diode and the other one to the end of said controlled switch opposite to said charge (M) ; and
— a second diode (DC1, DC2) of which one electrode is connected to a point (8, 8') common to said capacitor and to said first diode such that the anode (cathode) of the first diode is connected to the cathode (anode) of said second diode, the other electrode thereof being connected to a point (p) the potential of which is substantially fixed and greater or lower than the potential applied by said source to the end of the controlled switch opposite to said capacitor, according to whether this latter potential is negative or positive respectively,
characterized in that a main inductance (L21, L22) is mounted in series with said switch and in contiguity with the end thereof connected to said capacitor (C1, C2).

3. Device according to one of claims 1 or 2, characterized in that said point (7, p) of substantially fixed potential to which the capacitor (C, C', C1, C2) is connected by the second diode (DC, DC', DC1, DC2) is such that its potential corresponds to half E/2 of the voltage E withstood by the switch (T, T', T1, T2).

4. Device according to claims 2 or 3, characterized in that it presents the structure of a push-pull converter, and in that said point of substantially fixed potential is the positive p or negative n terminal of the D.C. source E opposite to the negative n or positive p terminal to which is connected the end of the controlled switch (T1, T2) opposite to the main inductance (L21, L22).

5. Device according to claim 3, characterized in that said point of substantially fixed potential is constituted by the centre point (7) of the source E.

6. Device according to any one of claims 1 to 5, characterized in that it presents the structure of a converter provided with a transformer insulating the charge of the controlled switches and in that each main inductance is formed by a leakage inductance of the transformer.

7. Device according to any one of claims 1 to 6, characterized in that it comprises a plurality of controlled switches (T, T', T1, T2) and in that with each of said controlled switches is associated a switching aid circuit comprising said capacitor (C, C', C1, C2), said first and second diodes (DL, DL', DL1, DL2-DC, DC', DC1, DC2), the main inductance (L2, L2', L21, L22) and the auxiliary inductance (L1, L1', L11, L12) and disposed as specified in Claim 1 or 2.

## Patentansprüche

1. Umschaltungsvorrichtung einer Gleichspannungsquelle (E) zum Speisen einer induktiven Last (M), der zumindest eine Freilaufdiode (D, D', DT, DT') zugeordnet ist, bestehend zumindest aus einem Betätigungsschalter (T, T') sowie einem passiven und nicht dissipativen Schalthilfekreis (CAC, CAC'), der
— ein C-Glied (C, C'), as auf der einen Seite (bei 5, 5') am auf die Last gerichteten Ende des Betätigungsschalters und auf der anderen Seite (bei 8, 8') an einer ersten Diode (DL, DL') liegt,
— eine Induktivität (L1, L1'), die mit der ersten Diode in Serie geschaltet ist, und

— eine zweite Diode (DC, DC') aufweist, die an dem dem C-Glied und der ersten Diode gemeinsamen Punkt (8, 8') derart verbunden ist, daß die Anode (Kathode) der ersten Diode an der Kathode (Anode) der zweiten Diode liegt,
dadurch gekennzeichnet, daß

— eine Hauptinduktivität (L2, L2') mit dem Schalter in Serie und angrenzend an dessen Ende am C-Glied (C, C') liegt ;

— das der ersten Diode (DL, DL') gegenüberliegende Ende (4, 4') der Induktivität (L1, L1') am der Last (M) gegenüberliegenden Ende des Betätigungsschalters liegt und

— die dem gemeinsamen Punkt (8, 8') gegenüberliegende Elektrode der zweiten Diode (DC, DC') an einem Punkt (7) liegt, dessen Potential gegenüber dem Potential, das von der Speisequelle ans dem C-Glied gegenüberliegende Ende des Betätigungsschalters gelegt wird, allgemein ruhend und höher oder niedriger ist, und zwar nach Maßgabe, ob das letztere Potential negativ bzw. positiv ist.

2. Umschaltvorrichtung einer Gleichspannungsquelle (E) zum Speisen einer induktiven Last (M) und bestehend aus einem Betätigungsschalter (T1, T2) sowie einem passiven und nicht dissipativen Schalthilfekreis (CAC1, CAC2), der

— ein C-Glied (C1, C2), das auf der einen Seite (bei 51, 52) am auf die Last gerichteten Ende des Betätigungsschalters und auf der anderen Seite (bei 8, 8') an einer ersten Diode (DL1, DL2) liegt,

— eine Induktivität (L11, L12), die mit einem Ende an der ersten Diode in Serie und mit dem anderen am der Last (M) gegenüberliegenden Ende des Betätigungsschalters liegt, und

— eine zweite Diode (DC1, DC2) aufweist, dessen eine Elektrode an dem dem C-Glied und der ersten Diode gemeinsamen Punkt (8, 8') liegt, so daß die Anode (Kathode) der ersten Diode mit der Kathode (Anode) der zweiten Diode und die andere Elektrode mit einem Punkt (p) verbunden ist, dessen Potential gegenüber dem Potential, das von der Speisequelle ans dem C-Glied gegenüberliegende Ende des Betätigungsschalters gelegt wird, allgemein ruhend und höher oder niedriger ist, und zwar nach Maßgabe, ob das letztere Potential negativ bzw. positiv ist,
dadurch gekennzeichnet, daß eine Hauptinduktivität (L21, L22) mit dem Schalter in Serie und angrenzend an dessen am C-Glied verbundenen Ende (C1, C2) liegt.

3. Umschaltvorrichtung nach einem der Ansprüche 1 oder 2, dadurch gekennzeichnet, daß der Punkt des allgemein ruhenden Potentials (7, p), mit dem das C-Glied (C, C', C1, C2) über die zweite Diode (DC, DC', DC1, DC2) verbunden ist, so ausgelegt ist, daß sein Potential der Hälfte E/2 der vom Schalter (T, T', T1, T2) getragenen Spannung E entspricht.

4. Vorrichtung nach den Ansprüchen 2 oder 3, dadurch gekennzeichnet, daß sie den Aufbau eines Gegentaktrichters besitzt und daß der Punkt des allgemein ruhenden Potentials die positive (p) oder negative (n) der negativen (n) oder positiven (p) Klemme gegenüberliegende Klemme der Gleichspannungsquelle E ist, an der das der Hauptinduktivität (L21, L22) gegenüberliegende Ende des Betätigungsschalters (T1, T2) angeschlossen ist.

5. Vorrichtung nach Anspruch 3, dadurch gekennzeichnet, daß der Punkt des allgemein ruhenden Potentials aus dem Mittelpunkt (7) der Quelle (E) besteht.

6. Vorrichtung nach einem der vorhergehenden Ansprüche 1 bis 5, dadurch gekennzeichnet, daß sie den Aufbau eines Umrichters besitzt, der mit einem die Last des Betätigungsschalters isolierenden Wandler (Transformator) versehen ist, und daß jede Hauptinduktivität als Erdschlußspule des Wandlers (Transformators) ausgebildet ist.

7. Vorrichtung nach einem der vorhergehenden Ansprüche 1 bis 6 gekennzeichnet durch mehrere Betätigungsschalter (T, T', T1, T2) und dadurch, daß jedem dieser Schalter ein Schalthilfekreis zugeordnet ist, der das C-Glied (C, C', C1 und C2), die erste und zweite Diode (DL, DL', DL1, DL2 — DC, DC', DC1, DC2), die Hauptinduktivität (L2, L2', L21, L22) und die Hilfsinduktivität (L1, L1', L11, L12) aufweist und nach den Angaben aus den Ansprüchen 1 oder 2 ausgelegt ist.

*Fig. 1*

*Fig. 3*

Fig. 2

**Fig. 4**

**Fig. 7**

Fig. 5

0 082 071

Fig. 6

Fig. 8

5